# EUROPEAN PATENT APPLICATION

(11) **EP 1 758 441 A2**
(43) Date of publication of application: **28.02.2007**
(21) Application number: 06254416.8
(22) Date of filing: 23.08.2006
(51) Int. Cl.: H05K 7/14

(54) **Screw-threaded fastening devices**

(30) Priority: 24.08.2005 GB 0517314
(71) Applicant: Engineering Dynamics (Southern) Limited, Andover SP10 3LU (GB)
(72) Inventor: Baker, John Kingsley, Stockbridge, SO20 8HA (GB); Weeks, David, Charlton, Andover SP10 4AT (GB); Larkin, James Anthony, Charlton, Andover SP10 4EQ (GB)
(74) Representative: Targett, Kenneth Stanley

(57) **Abstract**

A fastening device (10) has: a mounting member (12) attached to a first component (24), a screw-threaded assembly (14,22) rotatable in the mounting member and with a screw-threaded portion (32) for engaging with a screw-threaded portion (30) of a second component (28) to secure the components together; and an actuator member (18) mounted on the screw-threaded assembly. The device has, in itself, a locked state (Figure 1) and an unlocked state (Figure 2). A torque-transmitting arrangement (20,42,66) is arranged such that: when in the unlocked state, torque can be transmitted from the actuator member to the screw-threaded assembly to tighten the screw-threaded portions until a predetermined torque is reached, whereupon the device changes to its locked state; and when in the locked state, the actuator member is rotationally locked to the screw-threaded assembly. A locking arrangement (20,58,68) is arranged such that: when in the unlocked state, the actuator member can be rotated relative to the mounting member; and when in the locked state, the actuator member is rotationally locked to the mounting member.

## Description

This invention relates to fastening devices for screw-threadedly securing together two components.

The invention was conceived for use in fastening together avionics modules having complementary mating electrical connectors, but it can also be used to secure other components together.

Two avionics modules could be secured together by a simple rugged fastening device in the form of a screw-threaded bolt that passes through a hole in one module and engages a screw-threaded hole in the other module, or by a nut and bolt that act between the two modules. However, for reasons of reliability, safety, ease of maintenance and ease of inspection, in some applications requirements are imposed that the fastening device can easily be done up to a predetermined torque by hand without the use of tools, that it can be seen from visual inspection whether or not the fastening device has been done up properly, that the device will not loosen in service, that it can easily be undone by hand without the use of tools, and yet that the fastening device will remain rugged.

Various proposals have been made in the past in an attempt to satisfy some of these requirements. For example, patent document EP-0105609-B1 describes a manually-operable fastening device having a torque-limiting arrangement acting between an actuating knob and a main screw-threaded member and provided by balls seated in indents having inclined surfaces and to which spring loading is applied. When the limiting torque is reached, the balls ride out of the indents to that the knob turns without turning the screw-threaded member. In the specific embodiment described in EP-0105609-B1, it is possible to tell from visual inspection whether the device has been done up to some extent, but not whether it has been done up to the limiting torque. Furthermore, reliance is made purely on friction to prevent the device undoing itself in service.

Patent document EP-0304237-B1 describes developments to the device described in EP-0105609-B1. One development is to provide a ratchet arrangement between the actuating knob and a mounting member of the device so as to provide positive locking of the device once it has been done up. Once side effect of this is that the ratchet wears and makes an annoying click when the knob is being rotated to tighten the fastener. Another side effect is that, to undo the fastener, it is necessary to pull the knob axially all the time that it is being rotated in the undoing direction, and this causes operator wrist fatigue and is very annoying. Another development in EP-0304237-B1 is to provide a leaf spring or semaphore arm on the knob that changes its position to indicate when the device is done up. However, the arrangement described in EP-0304237-B1 only goes so far as indicating that the avionics modules have mated, and not that a predetermined force or torque has been reached. Also, the leaf spring or semaphore flag are prone to damage and can injure the operator's hand or at least make the knob uncomfortable to handle.

Patent document EP-0414835-B1 describes another development to the device described in EP-0304237-B1. In addition to having the torque limiting arrangement between the actuating knob and the screw-threaded member, it also has a force detecting arrangement, in the form of Belleville disc spring washers, in the indicating system so that the semaphore arm indicates that the device is done up only if both the modules are mated and at least a predetermined axial force is being applied by the screw-threaded member. That predetermined force is described as being less than the force that arises when the torque-limiting arrangement operates, and so the semaphore arm still does not indicate that the required torque has been reached. Furthermore, the Belleville washers react the whole of the axial force in the screw-threaded member. Therefore, if, in time, the Belleville washers relax and give, the force with which the avionics modules are held together decreases. Vibration can then arise between the electrical connectors in the avionics modules, leading to wear, arcing and system failure.

An aim of the present invention, or at least specific embodiments of it, is to provide a fastening device that satisfies at least some of the requirements set out above, but which does not suffer from some or all of the disadvantages of the prior art as described above.

In common with the device of patent document EP-0414835-B1, the present invention provides a fastening device for screw-threadedly securing together first and second components. The fastening device comprises a mounting member or assembly (hereinafter "the mounting assembly") arranged to be mounted on the first component; a screw-threaded member or assembly (hereinafter "the screw-threaded assembly") rotatably mounted relative to the mounting assembly and having a screw-threaded portion arranged to be engaged with a complementary screw-threaded portion of the second component in order to secure the first and second components together; and an actuator member or assembly (hereinafter "the actuator assembly") mounted relative to the mounting and screw-threaded assemblies. A torque-transmitting arrangement is provided between the screw-threaded and actuator assemblies, and a locking arrangement is provided between the actuator and mounting assemblies.

By contrast to the fastening device of patent document EP-0414835-B1, the device of the present invention has, in itself, distinct locked and unlocked states. The torque-transmitting arrangement is such that: when the fastening device is in its unlocked state, torque can be transmitted from the actuator assembly to the screw-threaded assembly in a direction to tighten the screw-threaded portions until a predetermined torque is reached, whereupon the fastening device changes to its locked state; and when the fastening device is in its locked state, the actuator assembly is rotationally locked to the screw-threaded assembly. The locking arrangement is such that: when the fastening device is in its unlocked state, the actuator assembly can be rotated relative to the mounting assembly; and when the fastening device is in its locked state, the actuator assembly is rotationally locked to the mounting assembly.

By comparison, the device of EP-0414835-B1 does not, in itself, have such locked and unlocked states. Instead, it has a single state in which the actuator member can always be turned in the tightening direction but cannot be turned in the loosening direction unless the actuator member is also pulled outwardly. Accordingly, there is no suggestion in EP-0414835-B1 of changing from an unlocked state to a locked state once a predetermined torque has been reached.

In order to allow the fastening device of the invention to be undone, preferably, when the fastening device is in its unlocked state, torque can be transmitted from the actuator assembly to the screw-threaded assembly in a direction to loosen the screw-threaded portions.

In a preferred embodiment, when the fastening device is in its unlocked state, the actuator assembly has a first longitudinal position, or range of positions, relative to the screw-threaded and mounting assemblies, and, when the fastening device is in its locked state, the actuator assembly has a second, different longitudinal position relative to the screw-threaded and mounting assemblies. In this case, the device is preferably arranged such that it can be changed from the locked state to the unlocked state by manually moving the actuator assembly in the longitudinal direction from the second position whilst rotating the actuator assembly in the direction to loosen the screw-threaded portions. Also, the locking arrangement preferably comprises a dog clutch, or the like, which engages upon movement of the actuator assembly from the first longitudinal position, or range of positions, to the second longitudinal position relative to the mounting assembly (i.e. upon changing of the device to the locked state). Furthermore, the torque-transmitting arrangement preferably comprises an arrangement of spring, cam and follower acting between the screw-threaded and actuator assemblies, such that, when the fastening device is in its unlocked state and torque is transmitted from the actuator assembly to the screw-threaded assembly in a direction to tighten the screw-threaded portions and the predetermined torque is neared, the follower rides up the cam against the action of the spring, and, once the predetermined torque is reached, the follower rides over the cam and the actuator assembly then moves under the action of the spring to the second longitudinal position relative to the screw-threaded assembly.

Preferably, the state of the fastening device can be detected by external visual inspection of it. In the case where the actuator has different longitudinal positions in the different states, the actuator and screw-threaded assemblies preferably have respective externally-visible surfaces that are flush with each other only when the actuator assembly is in the second longitudinal position relative to the screw-threaded assembly.

Specific embodiments of the present invention will now be described, purely by way of example, with reference to the accompanying drawings, in which:
- Figure 1: is a sectioned side view of a first embodiment of fastening device in its locked state;
- Figure 2: is a sectioned side view of the fastening device in its unlocked state;
- Figure 3: is an end view (in the direction A shown in Figure 1) of a mounting member of the fastening device;
- Figure 4: is an end view (in the direction A shown in Figure 1) of a screw-threaded member of the fastening device;
- Figure 5: is an isometric view of the screw-threaded member;
- Figure 6: is a development of as cam profile on the screw-threaded member;
- Figure 7: is an isometric view of a knob of the fastening device;
- Figure 8: is a sectioned side view of a second embodiment of fastening device;
- Figure 9: is an isometric view of a cam used in the fastening device of Figure 8; and
- Figure 10: is an isometric view, on a smaller scale, of the fastening device of Figure 8.

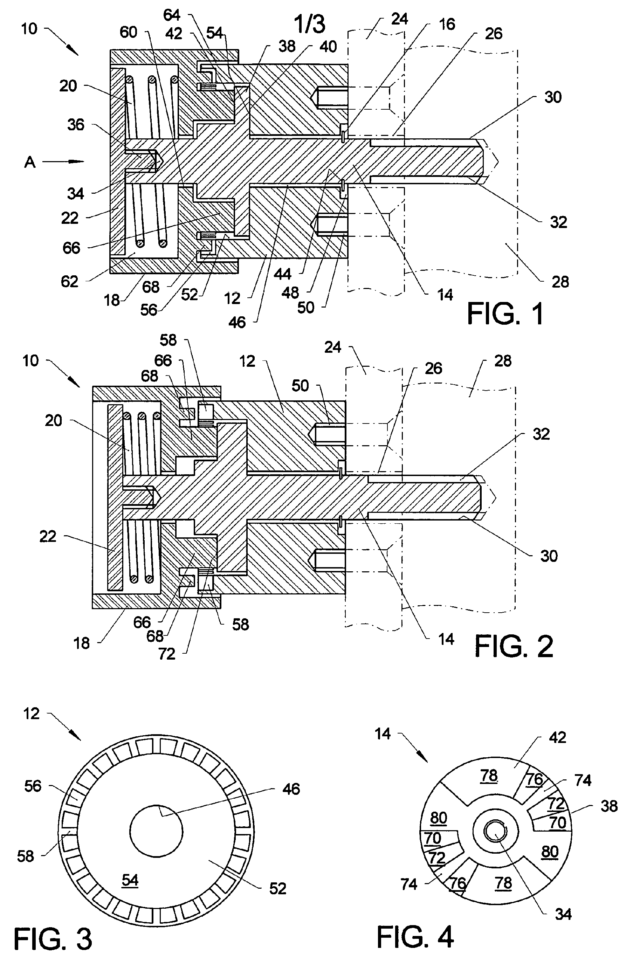

Referring in particular to Figure 1 of the drawings, the first embodiment of fastening device 10 comprises a mounting member 12, a screw-threaded member 14, an external circlip 16 for holding the screw-threaded member 14 captive with the mounting member 12, an actuator knob 18, a compression coil spring 20 and a spring retaining cover 22. The fastening device 10 is shown connecting a first component 24 having plain hole 26 to a second component 28 having a screw-threaded hole 30.

Referring in particular to Figures 1, 4 and 5, the screw-threaded member 14 has a shaft formed with an male screw-thread 32 at one end to complement the thread of the hole 30 in the second component 28. The other end of the shaft of the screw-threaded member 14 has a screw-threaded hole 34 that receives a threaded boss 36 on the inside of the spring retaining cover 22. Partway along the shaft of the screw-threaded member 14, a shoulder 38 is formed. The shoulder 38 has a thrust face 40 facing in the direction towards the end of the shaft with the male screw-thread 32, and a cam face 42 facing in the direction towards the end of the shaft with the threaded hole 34. Between the thrust face 40 and the end of the shaft with the male screw-thread 32, a groove 44 is formed to receive the circlip 16.

Referring in particular to Figures 1 and 3, the mounting member 12 is of generally circular cross-section and has a central hole 46 that receives the shaft of the screw-threaded member 14. A shallow counterbore 48 is formed in one end face of the mounting member 12 to accommodate the circlip 16. A pair of screw-threaded holes 50 are also formed in that end face, by which the mounting member 12 is permanently attached to the first component 24 using a pair of screws. A large, deep counterbore 52 is formed in the other end face of the mounting member 12 to receive the shoulder 38 of the screw-threaded member 14. The bottom of the counterbore 52 forms a thrust face 54 that is engaged by the thrust face 40 of the shoulder 38. The remaining periphery of the other end face of the mounting member 12 has a series of equally spaced notches 56 (for example twenty-four notches 56) cut into it so as to form a series of dogs 58 each between an adjacent pair of the notches 56.

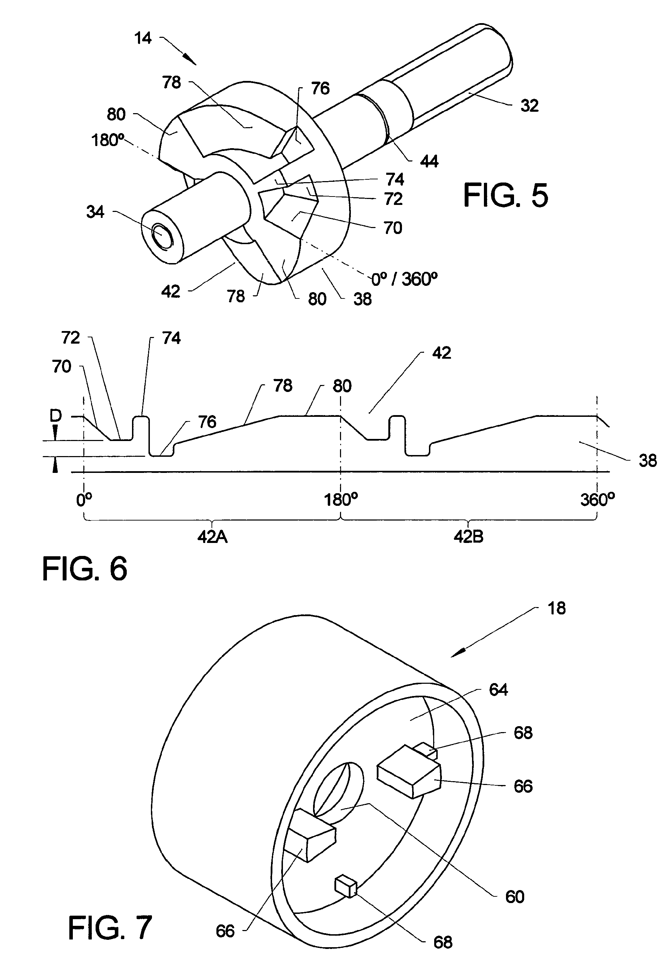

Referring in particular to Figures 1 and 7, the actuator knob 18 is of generally circular cross-section and has a central hole 60 that receives the shaft of the screw-threaded member 14. A large, deep counterbore 62 is formed in one end face of the knob 18 to house the spring 20. The other end face of the knob 18 is milled or otherwise machine to provide a recess 64, with two diametrically-opposed cam followers 66 and four equally-spaced dogs 68 (only two of which can be seen in Figure 7) projecting from the floor of the recess 64. The pitch circle diameter of the dogs 68 is generally equal to the pitch circle diameter of the dogs 58 and notches 56 on the mounting member 12, and the width of each dog 68 on the knob 18 is slightly less than the width of the notches 56 in the mounting member 12, so that the dogs 68 on the knob 18 can be interengaged with the dogs 58 on the mounting member 12 in any of twenty-four different angular positions. The cam followers 66 are arranged to engage with the cam face 42 on the screw-threaded member 14 as will now be described more detail with reference to Figures 3 to 7.

The cam followers 66 are arranged rotationally symmetrically through 180° about the axis of the knob 18, and the cam face 42 has two portions 42A,B (see Figure 6) that are rotationally symmetrical through 180° about the axis of the screw-threaded member 14. Referring in particular to Figure 6, starting at a datum position (0°) and moving anticlockwise around the axis of the screw-threaded member 14 (as viewed from the end having the screw-threaded hole 34), the cam face portion 42A has: a fairly steep, downwardly ramped portion 70; then a plateau portion 72 having generally the same width as each cam follower 66; then an upward step to a plateau portion 74; then a downward step to a plateau portion 76 having generally the same width as each cam follower 66; then a small step to a fairly gentle, upwardly ramped portion 78; and then a plateau portion 80 to the 180° position. The other cam face portion 42B then repeats the identical pattern.

As will be described in more detail below, when the cam followers 66 engage the plateau portions 76, the fastening device 10 is in its locked state, and when the cam followers 66 engage the plateau portions 72, the fastening device 10 is in its unlocked state. The difference D (Figure 6) in height between the plateau portions 72,76 is greater than the amount by which the dogs 58,68 on the mounting member 12 and the knob 18 interengage.

The fastening device 10 is assembled by fitting the screw-threaded member 14 into the mounting member 12 and fitting the circlip 16 into the groove 44. The knob 18 is then fitted to and screw-threaded member 14 with the cam followers 66 engaging the plateau portions 72 (as shown in Figure 2). The spring 20 is then fitted into the knob 18, and the retaining cover 22 is fitted to the screw-threaded member 14 and done up tightly. As seen in Figure 2, when the fastening device 10 is in its unlocked state, the outer face of the spring retaining cover 22 is recessed substantially into the knob 18.

The assembled fastening device 10 is mounted on the first component by inserting the end of the screw-threaded member 14 into the hole 26 in the first component 24 and by fitting the mounting screws into the holes 50 in the mounting member 12.

In order to connect the first component 24 to the second component 28, the screw-thread 32 on the screw-threaded member 14 is offered up to the screw-threaded hole 30 in the second component 28, and the knob 18 is rotated manually in the clockwise direction. In the unlocked state of the fastening device 10, the dogs 58,68 are not interengaged so that the knob 18 can be turned relative to the mounting member 12. Also, the cam followers 66 are pressed by the spring 20 onto the plateau portion 72 so that rotation of the knob 18 is transmitted to the screw-threaded member 14, and the screw-thread 32 enters the hole 30. Once the fastening device 10 starts to press the first component 24 against the second component 28, the torque required to turn the knob 18 increases and the cam followers 66 eventually begin to ride up the ramped portions 70 of the cam face 42. With increasing applied torque, the cam followers 66 eventually reach the tops of the ramped portions 70, slide over the plateau portions 80, slide down ramped portions 78 with the assistance of the force of the spring 20, and drop onto the plateau portions 76, as shown in Figure 1. The torque at which this happens is predetermined and is dependent, in the main, generally on the compressive force in the spring 20 as the followers 66 reach the tops of the ramped portions 70, the inclination of the ramped portions 70, the coefficient of friction between the followers 66 and the ramped portions 70, and the general pitch circle diameter of the followers 66 and ramped portions 70. When the followers 66 drop onto the plateau portions 76, the four dogs 68 on the knob 18 interengage between respective pairs of the dogs 58 on the mounting member 12, and so the knob 18 therefore becomes rotationally locked to the mounting member 12. Furthermore, the followers 66 are trapped between the steps to either side the plateau portions 76, and therefore the knob 18 becomes rotationally locked to the screw-threaded member 14. Accordingly, the whole fastening device 10 is rotationally locked with a predetermined torque having been applied.

As seen in Figure 1, when the fastening device 10 is in its locked state, the outer face of the spring retaining cover 22 is flush with the surrounding portion of the knob 18. It is therefore possible to detect, merely from visual inspection, whether the fastening device 10 is in its locked state. Without considerable abuse of the fastening device, it is impossible for it to take on its locked state unless the screw-threaded member 14 has been tightened to the required predetermined torque. Therefore, the flushness of the spring retaining cover 22 with the surrounding portion of the knob 18 is an almost foolproof indication that the screw-threaded member 14 has been tightened to the required predetermined torque.

In order to disconnect the first component 24 from the second component 28, the knob 18 is grasped and pulled outwardly against the action of the spring 20 while twisting anticlockwise. This action lifts the cam followers 66 off the plateau portions 76, and they ride up the gently-inclined ramped portions 78. With further twisting of the knob 18, the followers 66 ride over the plateau portions 80 and then fall down the ramped portions 70, under the action of the spring 20, and rest on the plateau portions 72. The fastening device 10 therefore attains its unlocked state. With further turning of the knob 18, the sides of the followers bear against the steps between the plateau portions 72 and the plateau portions 74, and so torque can be transmitted from the knob 18 to the screw-threaded member 14 in the direction to undo the screw-thread 32 without the need for continued outward pulling of the knob 18.

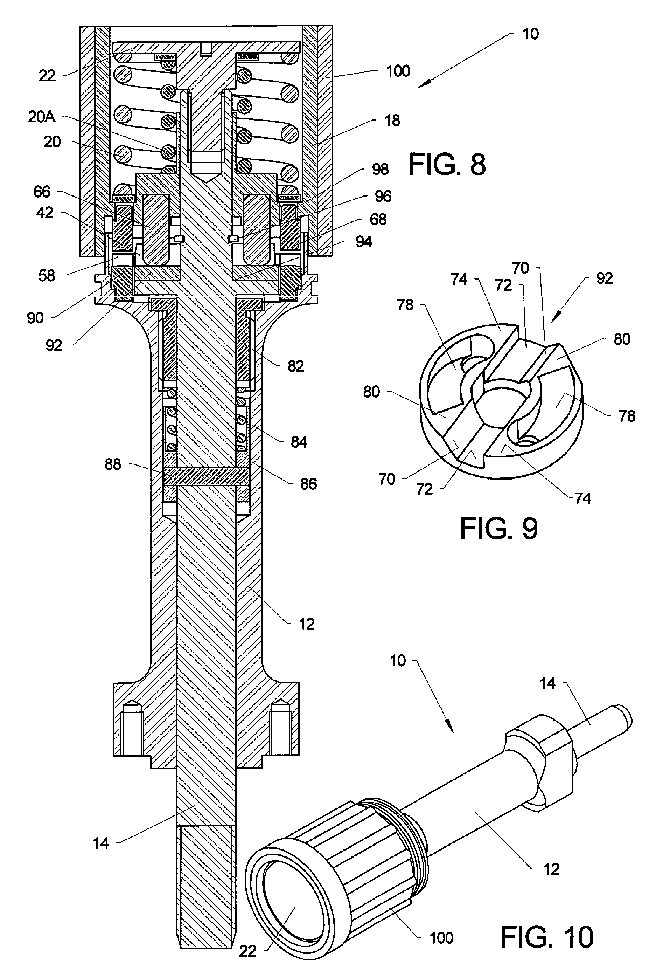

Figures 8 to 10 show a second embodiment of the fastening device 10 that employs the same principles as the first embodiment, but which has a number of modifications. For example, the screw-threaded member 14 is held captive in the mounting member 12 by a sleeve 82 that is screw-threaded into the mounting member 12 and acts through a compression coil spring 84 on a sleeve 86 that is fixed to the screw-threaded member 14 by a pin 88. The dogs 58 of the mounting member 12 are provided by a separate annular element 90 that is fixed to the mounting element 12. The cam face 42 is provided on a separate cam element 92 (Figure 9) that is keyed to the screw-threaded member 14 and held captive between a shoulder 94 and circlip 96 on the screw-threaded member 14. The cam followers 66 are provided by separate elements that are fixed to the knob 18. The cam followers 66 are formed by cylindrical pins with rounded ends. The dogs 68 of the knob 18 are provided on a separate annular element 98 that is fixed to the knob 18. A pair of springs 20,20A are provided acting between the knob 18 and the spring retaining cover 22. The knob 18 is covered with an 'easy-grip' sleeve 100.

It will be appreciated that many modifications and developments may be made to the fastening devices 10 described above. For example, the cam face 42 may be provided on the knob 18 and the follower or followers 66 may be provided on the screw-threaded member 14. The screw-threaded member 14 may alternatively have a female-threaded hole to engage a male-threaded projection on the second component 28.

It should be noted that the embodiments of the invention has been described above purely by way of example and that many other modifications and developments may be made thereto within the scope of the present invention.

## Claims

1. A fastening device (10) for screw-threadedly securing together first and second components (24,28), the fastening device comprising:
a mounting member or assembly (12) (hereinafter called "the mounting assembly") arranged to be mounted on the first component (24);
a screw-threaded member or assembly (14,22) (hereinafter called "the screw-threaded assembly") rotatably mounted relative to the mounting assembly and having a screw-threaded portion (32) arranged to be engaged with a complementary screw-threaded portion (30) of the second component (28) in order to secure the first and second components together; and
an actuator member or assembly (18) (hereinafter called "the actuator assembly") mounted relative to the mounting and screw-threaded assemblies;
wherein:
the fastening device has, in itself, a locked state (Figure 1) and an unlocked state (Figure 2);
a torque-transmitting arrangement (20,42,66) is provided between the screw-threaded and actuator assemblies such that:
when the fastening device is in its unlocked state, torque can be transmitted from the actuator assembly to the screw-threaded assembly in a direction to tighten the screw-threaded portions until a predetermined torque is reached, whereupon the fastening device changes to its locked state; and
when the fastening device is in its locked state, the actuator assembly is rotationally locked to the screw-threaded assembly; and
a locking arrangement (20,58,68) is provided between the actuator and mounting assemblies such that:
when the fastening device is in its unlocked state, the actuator assembly can be rotated relative to the mounting assembly; and
when the fastening device is in its locked state, the actuator assembly is rotationally locked to the mounting assembly.

2. A fastening device as claimed in claim 1, wherein, when the fastening device is in its unlocked state, torque can be transmitted from the actuator assembly to the screw-threaded assembly in a direction to loosen the screw-threaded portions.

3. A fastening device as claimed in claim 1 or 2, wherein, when the fastening device is in its unlocked state, the actuator assembly has a first longitudinal position, or range of positions, relative to the screw-threaded and mounting assemblies, and, when the fastening device is in its locked state, the actuator assembly has a second, different longitudinal position relative to the screw-threaded and mounting assemblies.

4. A fastening device as claimed in claim 3, and arranged such that the device can be changed from the locked state to the unlocked state by manually moving the actuator assembly in the longitudinal direction from the second position whilst rotating the actuator assembly in the direction to loosen the screw-threaded portions.

5. A fastening device as claimed in claim 3 or 4, wherein the locking arrangement comprises a dog clutch (58,68), or the like, which engages upon movement of the actuator assembly from the first longitudinal position, or range of positions, to the second longitudinal position relative to the mounting assembly.

6. A fastening device as claimed in any of claims 3 to 5, wherein the torque-transmitting arrangement comprises an arrangement of spring (20), cam (42,70-80) and follower (66) acting between the screw-threaded and actuator assemblies, such that, when the fastening device is in its unlocked state and torque is transmitted from the actuator assembly to the screw-threaded assembly in a direction to tighten the screw-threaded portions and the predetermined torque is neared, the follower rides up the cam (70) against the action of the spring, and, once the predetermined torque is reached, the follower rides over the cam (80,78) and the actuator assembly then moves under the action of the spring to the second longitudinal position relative to the screw-threaded assembly.

7. A fastening device as claimed in any preceding claim, wherein the state of the fastening device can be detected by external visual inspection of the fastening device.

8. A fastening device as claimed in any of claims 7 when dependent on any of claims 3 to 6, wherein the actuator and screw-threaded assemblies have respective externally-visible surfaces (18,22) that are flush with each other only when the actuator assembly is in the second longitudinal position relative to the screw-threaded assembly.
